Europäisches Patentamt

European Patent Office

Office européen des brevets

(19)

(11) Numéro de publication: **0 063 070**
**B1**

(12)                    **FASCICULE DE BREVET EUROPEEN**

(45) Date de publication du fascicule du brevet:
**12.09.84**

(51) Int. Cl.³: **H 01 L 23/30**, H 01 L 23/48

(21) Numéro de dépôt: **82400558.1**

(22) Date de dépôt: **26.03.82**

(54) **Boîtiers à cosses plates pour composants semiconducteurs de moyenne puissance, et procédé de fabrication.**

(30) Priorité: **08.04.81 FR 8107035**

(43) Date de publication de la demande:
**20.10.82 Bulletin 82/42**

(45) Mention de la délivrance du brevet:
**12.09.84 Bulletin 84/37**

(84) Etats contractants désignés:
**DE FR GB IT NL**

(56) Documents cités:
**FR - A - 2 188 305**
**GB - A - 1 161 488**

**ELECTRONIC DESIGN, volume 28, no. 18, septembre 1980, WASECA-DENVILLE (US) R. SHINN "Overmold package firm up TO-220 advantages", page 42**

(73) Titulaire: **THOMSON-CSF, 173, Boulevard Haussmann, F-75379 Paris Cedex 08 (FR)**

(72) Inventeur: **Collumeau, Yoland, THOMSON-CSF SCPI 173, bld Haussmann, F-75360 Paris Cedex 08 (FR)**

(74) Mandataire: **de Beaumont, Michel et al, THOMSON-CSF SCPI 173, Bld Haussmann, F-75379 Paris Cedex 08 (FR)**

ACTORUM AG

## Description

La présente invention concerne les boîtiers à cosses plates pour composants semiconducteurs de moyenne puissance.

Parmi les diverses techniques de montage des boîtiers semiconducteurs de puissance sur des appareils dans lesquels ils sont utilisés, une demande se fait sentir actuellement pour des boîtiers à cosses plates, notamment, des boîtiers à cosses répondant chacun à des normes pré-établies en ce qui concerne leurs dimensions linéaires et leurs épaisseurs, et permettant un câblage rapide à l'aide de connecteurs femelles venant s'emmancher sur lesdites cosses. Mais d'autres présentations de boîtiers à cosses plates sont demandées par des utilisateurs pour satisfaire des besoins de montage différents dans des appareils particuliers, notamment pour des montages série ou parallèle.

La présente invention prévoit un procédé de fabrication de boîtier tel que, dans la dernière étape de fabrication seulement, on puisse choisir entre différents modes de présentation et de conformation des pattes de connexion en fonction des desiderata d'un utilisateur particulier.

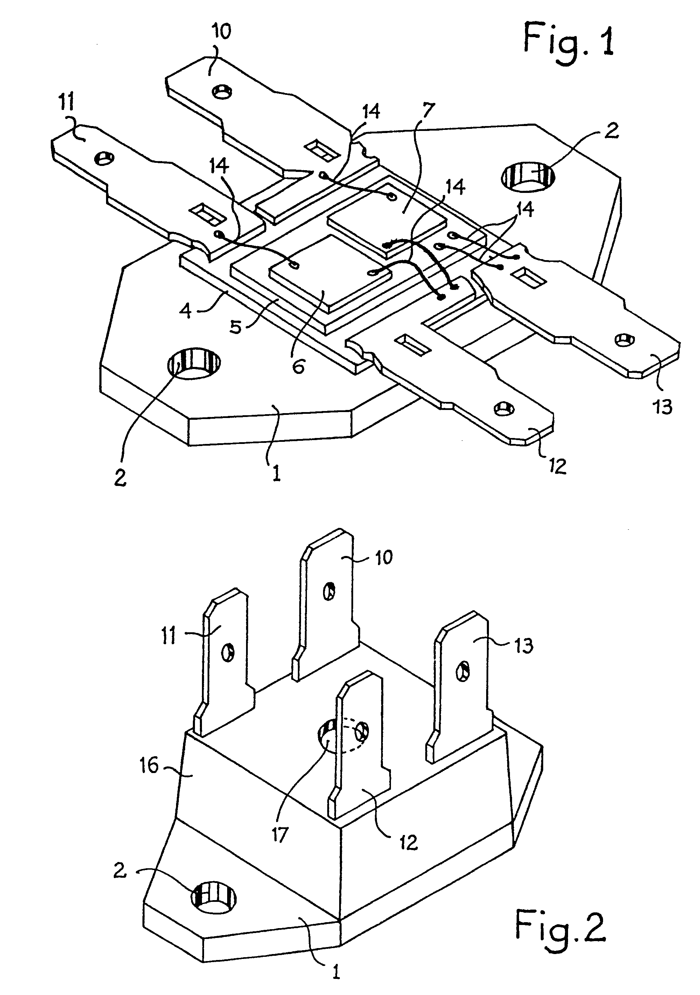

Avant de décrire la présente invention, et pour mieux faire ressortir son intérêt et ses avantages, on va décrire en relation avec les fig. 1 et 2 un exemple de boîtier à cosses selon la technique courante.

La fig. 1 représente en perspective un boîtier à cosses plates classiques lors d'une étape intermédiaire de fabrication avant encapsulation dans une matière plastique. Le boîtier comprend une embase 1 en un métal bon conducteur thermique, par exemple du cuivre revêtu d'une couche métallique propre à faciliter les soudures. Cette embase peut comprendre des alésages 2 destinés notamment à permettre sa fixation simple contre un radiateur. Sur l'embase est disposée une pièce 4 en forme de plaque d'un matériau isolant électriquement et aussi conducteur thermique que possible, par exemple de l'alumine métallisée sur ses deux faces principales. Sur la plaque isolante électriquement 4 est disposée une plaque 5 d'un matériau très bon conducteur thermique qui sera généralement conducteur électrique, par exemple une plaque de cuivre-revêtue d'un matériau propre à faciliter les brasures. Cette plaque a pour objet de répartir au mieux le flux thermique à évacuer par l'embase 1 avant que celui-ci ne traverse la plaque 4. Sur cette plaque 5 sont disposés un ou plusieurs composants semiconducteurs 6 et 7 sous forme de puce nue à faces métallisées. A titre d'exemple, ces composants peuvent être des transistors dont la face au contact avec la plaque conductrice 5 correspond au collecteur et dont la face supérieure comprend une borne de base et une borne d'émetteur. Les bornes de collecteurs sont donc interconnectées par la plaque métallique 5. Des parties latérales de la plaque électriquement isolante 4 portent des métallisations disjointes de la métallisation principale supérieure de cette plaque. Sur ces métallisations disjointes est brasée la partie proximale de plaquettes métalliques 10 à 13 dont les parties distales sont conformées selon des normes prédéterminées de cosses. Des bornes choisies de chacun des composants semiconducteurs 6 et 7 sont reliées par des fils conducteurs 14 à une zone de l'extrémité proximale des pattes ou cosses plates 10 à 13. La fig. 1 donne à titre d'exemple le câblage interne d'un montage darlington dans lequel le composant 6 est le transistor pilote, le composant 7 est le transistor de sortie, la connexion 11 est la base du pilote, la connexion 12 est la base de l'étage de sortie, la connexion 10 est l'émetteur et la connexion 13 est le collecteur.

Dans une étape de fabrication ultérieure, dont le résultat est illustré en fig. 2, les pattes 10 à 13 sont repliées vers le haut orthogonalement à la surface de l'embase et l'ensemble est moulé dans un bloc de matière plastique, par exemple une résine époxy 16. On peut opérer ou bien par moulage transfert en disposant le boîtier ou plutôt un ensemble de boîtiers dans un moule de conformation choisie, ou bien comme cela est plus particulièrement représenté en fig. 2, en utilisant une technique de moule perdu, c'est-à-dire en disposant un capot muni d'une ouverture 17 sur l'embase puis en coulant de la résine ou autre matière plastique dans ce capot.

Le boîtier décrit ci-dessus en relation avec les fig. 1 et 2 donne des résultats satisfaisants comme boîtier à cosses de type classique. Néanmoins, son inconvénient est que, après le moulage de la matière plastique d'encapsulation, on ne peut retoucher simplement les pattes de connexion ou les disposer selon une autre configuration pour permettre à l'utilisateur de disposer les pattes de connexion selon une autre configuration pour s'adapter à un mode de câblage particulier.

Un boîtier pour circuits intégrés dans lequel les pattes peuvent être pliées perpendiculairement à l'embase après enrobage est décrit dans la demande de brevet FR-A N° 2188305. Les mesures décrites dans le préambule de la revendication 3 sont également connues dudit document.

Pour atteindre cet objet consistant à prévoir un boîtier à cosses plates, à présentations multiples, la présente invention prévoit un boîtier pour composants semiconducteurs de moyenne puissance comprenant une embase métallique sur laquelle est monté au moins un composant semiconducteur, des pattes de connexion en forme de plaquettes métalliques étant reliées à diverses bornes des composants semiconducteurs et montées dans un plan sensiblement parallèle à celui de l'embase et faisant saillie au-delà de deux côtés de cette embase à laquelle elles sont fixées par l'intermédiaire d'une pièce isolante, l'ensemble des composants semiconducteurs et des connexions étant noyé dans un bloc de matière plastique isolante. Ce bloc de matière plastique isolante est conformé de sorte que, le long des côtés de l'embase d'où dépassent les connexions, ce bloc de matière plastique isolante est en retrait par rapport au contour de l'embase au moins aux emplacements d'où font saillie les pattes de connexion, d'où il résulte que, après formation du bloc de matière plastique, les pattes de connexion peuvent être repliées perpendiculairement à l'embase et/ou découpées selon toute configuration choisie sans déborder par rapport à l'embase. Ainsi, le procédé de fabrication d'un boîtier tel que décrit ci-dessus comprend les étapes consistant à enrober d'un bloc de matière plastique les composants semiconducteurs et une partie proximale des pattes de connexion alors que celles-ci sont à plat, parallèles au plan de l'embase et en saillie par leur partie distale par rapport à certains côtés de l'embase, les parois du bloc orthogonales à l'embase et parallèles auxdits côtés étant en retrait par rapport à ces côtés aux emplacements où les pattes font saillie, puis à découper et former ensuite les pattes selon un modèle choisi. Le bloc de résine peut comprendre, selon chacun des côtés d'où dépassent les connexions, des portions de parois orthogonales à l'embase et à l'aplomb de celle-ci entre et/ou au-delà des pattes de connexion.

Dans l'étape finale de découpe et de conformation des pattes, on pourra notamment opter pour l'une des solutions suivantes:

— maintenir une des pattes de chaque côté de l'embase parallèle à celle-ci, cette patte étant percée d'un alésage propre à laisser le passage à une vis de fixation, les autres pattes étant repliées;

— découper chacune des pattes selon des normes pré-établies puis les replier perpendiculairement à l'embase;

— munir la face supérieure du bloc de matière plastique isolante disposée dans un plan parallèle à l'embase d'au moins un évidement propre à recevoir un écrou prisonnier;

— former un alésage dans au moins l'une des pattes;

— procéder à un double repliement de cette patte, sa partie distale se trouvant alors parallèle à la face supérieure, suffisamment proche de cette patte pour bloquer l'écrou prisonnier, et l'alésage étant en regard du filetage de cet écrou.

Ces objets, caractéristiques ainsi que d'autres avantages de la présente invention seront exposés plus en détail dans la description suivante de modes de réalisation particuliers faits en relation avec les figures jointes, parmi lesquelles:

la fig. 1 représente en perspective une étape intermédiaire de fabrication d'un boîtier à cosses plates;

la fig. 2 représente en perspective une vue d'un boîtier à cosses de configuration classique;

la fig. 3 représente une vue en perspective d'un boîtier à cosses plates selon la présente invention;

les fig. 4A, 5A et 6A représentent des vues de dessus, et

les fig. 4B, 5B et 6B représentent des vues de côté en coupe correspondantes de diverses configurations que l'on peut donner aux pattes de connexion d'un boîtier selon l'invention.

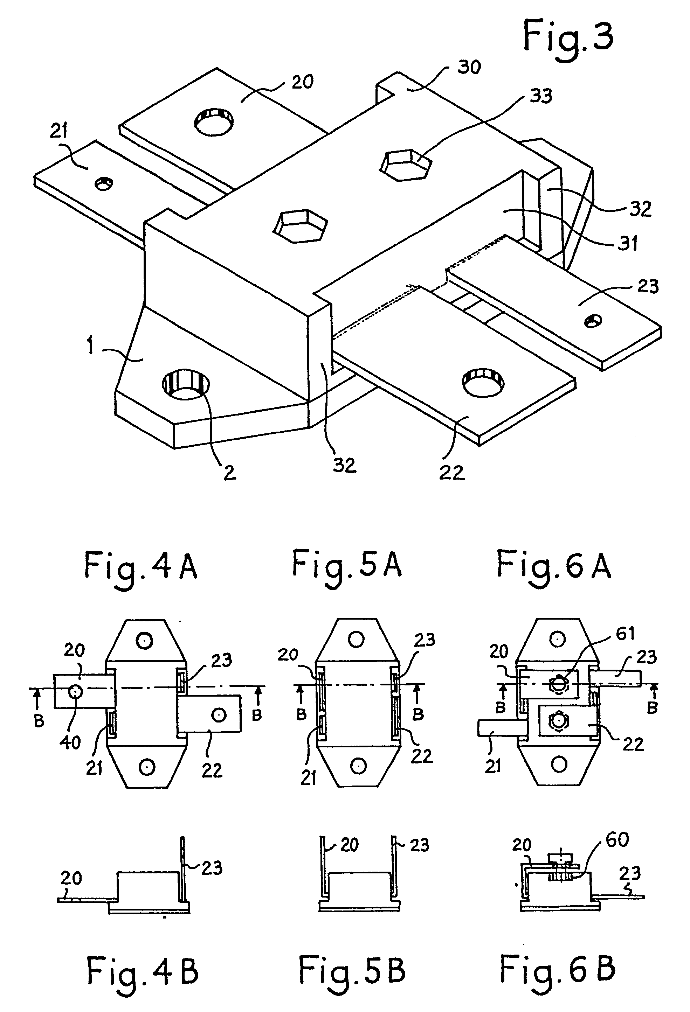

La fig. 3 représente une vue en perspective d'un boîtier selon la présente invention. Ce boîtier, comme celui de la fig. 1, peut comprendre une embase 1 munie de trous de fixation 2. Le montage interne des composants semiconducteurs sur l'embase, non visible en fig. 3, peut être analogue à celui représenté en fig. 1. La différence entre la fig. 3 et la fig. 1, pour les parties communes, réside essentiellement dans le fait que les pattes de connexion 20 à 23 du boîtier de la fig. 3 n'ont pas, lors de l'étape intermédiaire de fabrication de la fig. 1, de forme particulière, mais sont conformées pour pouvoir ensuite, comme on le verra ci-après, être découpées ou percées selon diverses configurations choisies.

Par rapport au boîtier de l'art antérieur, illustré en fig. 2, le boîtier de la fig. 3 diffère essentiellement en ce que le bloc de matière plastique, couramment de la résine époxy, d'encapsulation est formé alors que les pattes de connexion 20 à 23 sont encore disposées à plat. Le bloc de substance d'encapsulation 30 présente des faces 31 en retrait par rapport à la verticale (selon la représentation de la figure) des côtés de l'embase aux emplacements d'où font saillie des connexions 20 à 23. Cela permet de replier ensuite vers le haut ces pattes de connexion sans qu'elles débordent latéralement à l'extérieur du contour de l'embase 1. D'autre part, le bloc de matière plastique comprend des faces en saillie verticales 32 à l'aplomb des côtés de l'embase en dehors des emplacements d'où saillent les pattes de connexion 20 à 23. Il a été représenté en fig. 3 de telles faces aux extrémités du bloc. On pourrait également prévoir une face en saillie par exemple entre les pattes 22 et 23. Le rôle de ces faces en saillie est de réduire les fuites de courant et d'éviter des courts-circuits éventuels qui pourraient se produire si une barre conductrice venait à être appliquée latéralement contre le boîtier mettant en court-circuit les pattes 22 et 23 ou 20 et 21. La face supérieure du bloc de matière isolante 30 comprend un ou plusieurs évidements 33 ayant une forme propre à recevoir des écrous dont ils empêchent une éventuelle rotation lors d'un vissage ou d'un dévissage.

Les fig. 4 à 6 représentent diverses conformations que l'on peut donner aux pattes de connexion d'un boîtier tel que celui de la fig. 3, dans lequel on a supposé qu'il était prévu quatre pattes de connexion 20 à 23 dont deux (20 et 22) correspondent à des électrodes principales et les deux autres (21 et 23) correspondent à des électrodes secondaires parcourues par des courants moins intenses. Par exemple, les pattes 20 et 22 correspondent aux bornes d'émetteur et de collecteur d'un transistor ou d'une association de transistors de type darlington ou autre. Dans le cas des fig. 4A, 4B, les pattes de connexion principales 20 et 22 sont maintenues à plat après avoir été percées d'un alésage 40 propre à laisser passer une vis de fixation. Les pattes de commande 21 et 23 sont repliées, par exemple de la façon illustrée en fig. 4B. Ce montage se prête bien à relier ensemble, en parallèle entre des barres, plusieurs composants identiques, toutes les pattes 20 d'un ensemble de boîtiers étant reliées à une première barre et toutes les pattes 22 de cet ensemble de boîtiers étant reliées à une deuxième barre. Dans un tel assemblage, les pattes 21 d'une part, et les pattes 23 d'autre part, peuvent être reliées entre elles soit par d'autres barres, soit par un câblage réalisé avec des connecteurs répondant à des normes prédéterminées suivant le cas envisagé, les pattes 21 et 23 auront été soit percées de trous, soit découpées selon des normes prédéterminées avant d'être pliées.

Dans le cas des fig. 5A, 5B, toutes les pattes sont découpées selon des normes prédéterminées puis repliées vers le haut pour fournir un boîtier ayant le même usage que le boîtier de la fig. 2 décrit et représenté précédemment.

Dans le cas des fig. 6A, 6B, un écrou 60 est inséré dans chacun des trous borgnes 33. Les pattes principales sont découpées et munies d'un alésage 61 de façon à pouvoir être repliées deux fois de la façon illustrée et à venir se rabattre sur la paroi supérieure du boîtier en maintenant prisonnier l'écrou 60, l'alésage 61 se trouvant en face du trou fileté de cet écrou. Ce mode de réalisation permet également des associations simples au moyen de jeux de barres en série ou en parallèle de plusieurs boîtiers tels que représentés. Dans le cas illustré, les pattes de commande 21 et 23 sont laissées à plat mais on pourra leur donner toute autre conformation selon le montage prévu pour le boîtier.

Ainsi, la présente invention permet de fabriquer des boîtiers standards tels qu'illustrés en fig. 3, puis ensuite seulement, éventuellement après stockage, de donner aux pattes de connexion une conformation choisie selon les souhaits d'un utilisateur. Cela permet de simplifier les problèmes de stock et de prévoir une fabrication unique pour des utilisations différentes.

Bien entendu, la présente invention est susceptible de nombreuses variantes. Par exemple, l'embase 1 a été représentée comme présentant des prolongements trapézoïdaux en dehors de la zone recouverte par l'encapsulation. Cette embase pourra être rectangulaire et se limiter à la zone revêtue d'une encapsulation ou avoir toute autre forme choisie. La partie interne du boîtier pourra être autre que celle illustrée en fig. 1. A titre d'exemple, la plaque conductrice 5 pourra être remplacée par deux plaques brasées sur deux plages isolées électriquement sur la plaque isolante 4. Le boîtier pourra alors contenir deux composants, par exemple deux diodes, qui seraient totalement isolées entre elles. Ou, au contraire, les composants semiconducteurs pourront être directement soudés sur le boîtier sans interposition d'une substance isolante 4.

Conformément à la pratique courante dans le domaine de la fabrication des semiconducteurs, les pattes 20 à 23 ne sont en fait pas fixées isolément l'une après l'autre sur l'embase 1 (par l'intermédiaire d'une pièce isolante); au contraire, il est réalisé, au cours d'une opération simultanée, un grand nombre de soudures sur plusieurs boîtiers en cours de fabrication, les pattes de connexion étant solidarisées les unes aux autres selon une «grille de connexion». Les diverses pattes sont solidarisées les unes aux autres, des jours étant seulement prévus aux endroits où on prévoit de les séparer. Ainsi, l'étape de découpe, par exemple par emboutissage, des pattes pour donner à chacune une forme choisie et la munir d'alésages de dimensions déterminées ne constitue pas une étape supplémentaire par rapport aux étapes classiques de fabrication d'un boîtier, étant donné que de toute manière cette étape d'emboutissage doit être prévue pour séparer chacune des pattes de connexion de la «grille de connexion».

## Revendications

1. Boîtier pour composants semiconducteurs de moyenne puissance comprenant une embase métallique sur laquelle est monté au moins un composant semiconducteur, des pattes de connexion en forme de plaquettes métalliques (20 à 23) étant reliées à diverses bornes de ces composants et montées dans un plan sensiblement parallèle de celui de l'embase à laquelle elles sont fixées par l'intermédiaire d'une pièce isolante, ces pattes, dans leur état non replié, faisant saillie au-delà de deux côtés de l'embase, l'ensemble des composants semiconducteurs et des connexions au-dessus de l'embase étant noyé dans un bloc (30) de matière plastique isolante, caractérisé en ce que le long desdits côtés, le bloc de résine est en retrait par rapport au contour de l'embase au moins aux emplacements (31) d'où saillent les pattes, d'où il résulte que, après formation du bloc de matière plastique isolante, les pattes de connexion peuvent être repliées perpendiculairement à l'embase sans déborder latéralement par rapport à celle-ci.

2. Boîtier selon la revendication 1, caractérisé en ce que la face supérieure du bloc de matière plastique est muni d'au moins un évidement (33) conformé pour recevoir et bloquer en rotation un écrou de fixation.

3. Procédé de fabrication d'un boîtier pour composants semiconducteurs comprenant une embase métallique (1) ayant deux côtés parallèles sur laquelle est monté au moins un composant semiconducteur associé à des pattes de connexion sous forme de plaquettes métalliques (20 à 23) faisant saillie par rapport auxdits côtés parallèles de l'embase, comprenant les étapes suivantes:

— enrober d'un bloc de matière plastique (30) les composants semiconducteurs et une partie proximale des pattes qui sont à plat, parallèles au plan de l'embase, et en saillie par leurs parties distales par rapport auxdits côtés de l'embase, et

— découper et former ensuite les pattes selon un modèle choisi, caractérisé en ce que les parois (31) du bloc sont formées de façon qu'elles soient orthogonales à l'embase, et en retrait par rapport à ces côtés aux emplacements où les pattes font saillie.

4. Dispositif obtenu par le procédé de la revendication 3, caractérisé en ce que le bloc de résine comprend, selon chacun desdits côtés, des portions de parois (32) orthogonales à l'embase et à l'aplomb de celle-ci.

5. Procédé selon la revendication 3, caractérisé en ce que, après l'enrobage, l'une des pattes de chaque côté est maintenue parallèle à l'embase et percée d'un alésage propre à laisser le passage à une vis de fixation, les autres pattes étant repliées.

6. Procédé selon la revendication 3, caractérisé en ce que, après l'enrobage, chacune des pattes est découpée selon une norme établie et repliée perpendiculairement à l'embase.

7. Dispositif obtenu par le procédé de la revendication 3, caractérisé en ce que la face du bloc de matière plastique isolante supérieure, parallèle à l'embase, est munie d'au moins un évidement propre à recevoir un écrou prisonnier et en ce qu'au moins l'une des pattes comprend un alésage positionné pour que, après deux repliements successifs, la partie distale aux semiconducteurs de cette patte se trouve parallèle à la face supérieure, suffisamment proche de cette face pour bloquer l'écrou prisonnier, l'alésage étant alors en regard du filetage de l'écrou.

## Patentansprüche

1. Gehäuse für Halbleiterbauteile mittlerer Leistung, mit einer metallischen Basis, auf der mindestens ein Halbleiterbauteil montiert ist, und mit Anschlussfahnen in Form von Metallplättchen (20 bis 23), die mit verschiedenen Anschlüssen dieser Bauteile verbunden sind und in einer zur Basis, auf der sie über ein Isolierstück befestigt sind, im wesentlichen parallelen Ebene montiert sind, wobei diese Anschlussfahnen in ihrem nicht umgebogenen Zustand über zwei Seiten der Basis vorstehen und wobei die Gesamtheit aus Halbleiterbauteilen und Anschlüssen oberhalb der Basis in einen Block (30) aus einem isolierenden Kunststoff eingegossen ist, dadurch gekennzeichnet, dass der Kunststoffblock entlang der Seiten bezüglich der Umrisse der Basis zumindest an den Stellen (31) zurückversetzt ist, an denen die Fahnen vorstehen, woraus resultiert, dass nach dem Giessen des isolierenden Kunststoffblocks die Anschlussfahnen senkrecht zur Basis umgebogen werden können, ohne seitlich über die Basis vorzustehen.

2. Gehäuse nach Anspruch 1, dadurch gekennzeichnet, dass die Oberseite des Kunststoffblocks mindestens eine Aushöhlung (33) aufweist, die so gestaltet ist, dass sie eine Befestigungsmutter aufnehmen und in Drehrichtung blockieren kann.

3. Verfahren zur Herstellung eines Gehäuses für Halbleiterbauteile mit einer metallischen Basis (1), die zwei parallele Seiten aufweist und auf der mindestens ein Halbleiterbauteil mit den zugehörigen Anschlussfahnen in Form von Metallplätchen (20 bis 23) montiert ist, die über die parallelen Seiten der Basis vorstehen, wobei das Verfahren folgende Schritte aufweist:

— Einhüllung der Halbleiterbauteile und eines daran angrenzenden Teils der flachen und zur Ebene der Basis parallelen Anschlussfahnen in einen Kunststoffblock (30), wobei die Enden der Fahnen bezüglich der Seiten der Basis vorstehen,

— Beschneiden und anschliessende Ausformung der Anschlussfahnen gemäss einem gewählten Modell, dadurch gekennzeichnet, dass die Wände (31) des Blocks so geformt sind, dass sie senkrecht zur Basis und bezüglich deren Seiten an den Stellen, an denen die Anschlussfahnen vorstehen, zurückgesetzt verlaufen.

4. Vorrichtung, die nach dem Verfahren gemäss Anspruch 3 erhalten wird, dadurch gekennzeichnet, dass der Kunstharzblock an jeder dieser Seiten Wandbereiche (32) besitzt, die zur Basis senkrecht und ihr gegenüber nicht zurückgesetzt verlaufen.

5. Verfahren nach Anspruch 3, dadurch gekennzeichnet, dass nach dem Giessen je eine Fahne auf jeder Seite zur Basis parallel gehalten wird und mit einer Bohrung versehen wird, die geeignet ist, um eine Befestigungsschraube durchzulassen, während die anderen Fahnen umgebogen werden.

6. Verfahren nach Anspruch 3, dadurch gekennzeichnet, dass nach dem Giessen des Blocks die Anschlussfahnen nach einer gegebenen Norm zurechtgeschnitten und senkrecht zur Basis umgebogen werden.

7. Vorrichtung, die durch das Verfahren gemäss Anspruch 3 erhalten wird, dadurch gekennzeichnet, dass die obere Seite des isolierenden Kunststoffblocks, die parallel zur Basis verläuft, mindestens eine Höhlung aufweist, die geeignet ist, um eine Schraubenmutter einzusperren, und dass mindestens eine der Fahnen eine Bohrung aufweist, die so angebracht ist, dass nach zwei aufeinanderfolgenden Umbiegungen der von den Halbleitern am weitesten entfernte Bereich dieser Fahne sich parallel zur oberen Seite und hinreichend nahe an dieser Seite befindet, um die eingesperrte Schraube zu blockieren, wobei dann die Bohrung sich gegenüber dem Gewinde der Schraubenmutter befindet.

## Claims

1. A casing for medium power semi-conductor components comprising a metal base on which is mounted at least one semi-conductor component, connecting lugs in the form of small metal plates (20 to 23) being connected to different terminals of these components and mounted in a plane substantially parallel to that of the base to which they are fixed through an insulating member, these lugs projecting before being bent from both sides of the base, the assembly of the semi-conductor components and connections above the base being embedded in a block (30) of insulating plastic material, characterized in that along said sides, the block of resin is recessed with respect to the contour of the base at least at the position (31) where said lugs project, which results, after formation of the insulating plastic material block, in the connecting lugs being able to be bent perpendicularly to said base without projecting laterally beyond said base.

2. A casing according to claim 1, characterized in that the upper face of said plastic material block is provided with at least one recess (33) shaped so as to receive and secure against rotation a fixing nut.

3. A method for manufacturing a casing for semi-conductor components comprising a metal base (1) having two parallel sides on which is mounted at least one semi-conductor component associated with connecting lugs in the form of small metal plates (20 to 23) projecting with respect to said parallel sides beyond the base, this method comprising the following steps:

— covering with a block of plastic material (30) the semi-conductor components and a proximal part of said lugs when they are flat, parallel to the plane of the base and projecting with their distal parts with respect to said sides of the base,

— czutting out and then shaping said lugs in accordance with a chosen pattern, characterized in that the walls (31) of said block are orthogonal to the base and recessed with respect to said sides at the positions where said lugs project.

4. A device obtained by the method according to claim 3, characterized in that the block of resin comprises along each of its sides wall portions (32) which are orthogonal to said base and plumb therewith.

5. A method according to claim 3, characterized in that one of the lugs on each side is maintained parallel to said base after the embedding step and pierced with a bore adapted to let a fixing screw pass therethrough, the other lugs being bent.

6. A method according to claim 3, characterized in that after the embedding step, each of the lugs is cut out in accordance with an established standard and bent perpendicularly to the base.

7. A device obtained by the method according to claim 3, characterized in that the upper face of the block of insulating plastic material, parallel to the base, is provided with at least one recess adapted to receive an anchor nut, and that at least one of said lugs comprises a bore positioned so that, after being bent twice successively, the distal part of this lug is parallel to said upper face, sufficiently close to this face to lock the anchor nut, the bore being then opposite the thread of the nut.

Fig. 1

Fig. 2

Fig.3

Fig.4 A  Fig.5 A  Fig.6 A

Fig.4 B  Fig.5 B  Fig.6 B